Europäisches Patentamt

European Patent Office

Office européen des brevets

(19)

(11) **EP 0 530 912 B1**

(12) **EUROPÄISCHE PATENTSCHRIFT**

(45) Veröffentlichungstag und Bekanntmachung des Hinweises auf die Patenterteilung:
**07.01.1998   Patentblatt 1998/02**

(51) Int Cl.6: **H03G 7/00**, H04B 1/30

(21) Anmeldenummer: **92202642.2**

(22) Anmeldetag: **01.09.1992**

(54) **Funkempfänger mit analoger Dynamikkompression und digitaler Expandierung**

Receiver with analog compression and digital expansion

Récepteur comprennant un compresseur analogique et un décompresseur numérique

(84) Benannte Vertragsstaaten:
**DE ES FR GB IT**

(30) Priorität: **06.09.1991  DE 4129681**

(43) Veröffentlichungstag der Anmeldung:
**10.03.1993   Patentblatt 1993/10**

(73) Patentinhaber:
• **Philips Patentverwaltung GmbH**
  **22335 Hamburg (DE)**
  Benannte Vertragsstaaten:
  **DE**
• **Philips Electronics N.V.**
  **5621 BA Eindhoven (NL)**
  Benannte Vertragsstaaten:
  **ES FR GB IT**

(72) Erfinder:
• **Baier, Alfred,**
  **c/o Philips Patentverwaltung GmbH**
  **W-2000 Hamburg 1 (DE)**
• **Heinrich, Gerd,**
  **c/o Philips Patentverwaltung GmbH**
  **W-2000 Hamburg 1 (DE)**

(74) Vertreter: **Volmer, Georg, Dipl.-Ing. et al**
  **Philips Patentverwaltung GmbH,**
  **Röntgenstrasse 24**
  **22335 Hamburg (DE)**

(56) Entgegenhaltungen:
EP-A- 0 482 927          DE-A- 2 340 097
DE-A- 3 126 148          DE-A- 3 925 305
US-A- 4 282 578          US-A- 4 544 916

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

## Beschreibung

Die Erfindung betrifft einen Funkempfänger gemäß dem Oberbegriff des Patentanspruchs 1.

Derartige Funkempfänger sind beispielsweise im gesamteuropäischen Mobilfunksystem GSM einsetzbar. Bei diesem Mobilfunksystem werden Sprachsignale in digitalisierter Form zusammen mit anderen digitalen Signalen in einem Zeit-Vielfach-Zugriffs-Verfahrens (TDMA = Time Division Multiple Access) übertragen.

Aus DE 39 25 305 A1 ist ein Funkempfänger der eingangs genannten Art bekannt. Dabei wird in einem analogen Empfangsteil des Funkempfängers das empfangene Nachrichtensignal frequenzselektiert und mittels eines Mischers in eine Zwischenfrequenz umgesetzt. An den ZF-Mischer schließt sich ein ZF-Verstärker an, der eine nichtlineare Dynamikkompression durchführt. Hierdurch wird das Eingangssignal des ZF-Verstärkers, je nach Eingangspegel entweder komprimiert oder begrenzt. Das Ausgangssignal des ZF-Verstärkers wird einem Basisbandumsetzer zugeführt, der daraus zwei Quadraturkomponenten erzeugt. Diese Quadraturkomponenten werden abgetastet und einem Analog/Digital-Umsetzer zugeführt. Anschließend erfolgt in einem digitalen Signalverarbeitungsteil eine Zwischenspeicherung der abgetasteten digitalen Werte sowie eine Kanalschätzung und eine Entzerrung bzw. Dekodierung. Durch die nichtlineare Dynamikkompression und die Begrenzung wird erreicht, daß ein preisgünstiger A/D-Wandler mit einer geringen Anzahl von Quantisierungsstufen einsetzbar ist, wobei auch bei größtmöglichen Eingangspegeln des Nachrichtensignals keine Übersteuerung des A/D-Wandlers auftritt und trotzdem bei kleinstmöglichen Eingangspegeln noch verwertbare Abtastwerte geliefert werden. In der Praxis hat sich gezeigt, daß das Ausgangssignal des digitalen Signalverarbeitungsteils Bitfehler aufweist.

Aus der DE 31 26 148 A1 ist eine Anordnung bekannt, bei der einem A/D-Wandler gemäß einer pseudologarithmischen durch lineare Segmente approximierten Kompanderkennlinie vorverzerrte pulscodemodulierte Signale zugeführt werden. Bei der Rückwandlung in entsprechende Analogsignale werden die vom A/D-Wandler gelieferten Datenworte gemäß der inversen Funktion der Kompanderkennlinie in ein Datenwort umgesetzt, aus dem mittels eines D/A-Wandlers entzerrte Analogsignale gewonnen werden. Die Umsetzung von Datenworten anhand der inversen Funktion der Kompanderkennlinie erfolgt mit Hilfe einer entsprechend programmierten Speichermatrix. Die inverse Funktion der Kompanderkennlinie (Expanderkennlinie) entspricht dabei einer stückweise linaren Kennlinie. Wie die Speichermatrix letztendlich programmiert ist und wie die Speichermatrix die Expanderkennlinie umsetzt, ist nicht näher erläutert. Es ist lediglich eine Formel angegeben, die den Verlauf der Expanderlinie beschreibt.

Aus der US 4,282,578 ist ein System zur Linearisierung nichtlinearer Wandlersignale bekannt. Als Beispiele für nichtlineare Wandler sind Thermoelemente, Dehnungsmeßstreifenbrücken und Drucksensoren genannt. Die nichtlinearen Wandlersignale werden einem A/D-Wandler zugeführt. Eine bestimmte Anzahl höherwertige Bits der vom A/D-Wandler erzeugten Datenworte wird zur Adressierung von in einem ROM ("read only memory") in Tabellenform gespeicherter Datenworte verwendet. Eine bestimmte Anzahl höherwertige Bits der im ROM gespeicherten Datenworte dienen zur Bestimmung der Eckpunkte einer stückweise linearen Kurve, die den Zusammenhang zwischen den nichtlinearen vom A/D-Wandler gelieferten Daten und den linearisierten vom Linearisierungssystem gelieferten Daten beschreibt. Die übrigen geringerwertigen Bits der im ROM gespeicherten Datenworte beschreiben jeweils die Steigung der stückweise linearen Kurve zwischen zwei Knickpunkten. Diese geringerwertigen Bits werden einer Multipliziererschaltung zugeführt, deren weiteren Eingängen die geringerwertigen Bits der vom A/D-Wandler erzeugten Datenworte zugeführt werden. Die Multipliziererschaltung multipliziert die Datenworte, die aus den geringerwertigen Bits der vom A/D-Wandler gelieferten Datenworte bestehen, mit den Datenworten, die aus den geringerwertigen Bits der im ROM gespeicherten Datenworte bestehen. Eine bestimmte Anzahl höherwertige Bits der von der Multipliziererschaltung erzeugten Produktdatenworte werden mit den höherwertigen Bits der im ROM gespeicherten Datenworte addiert, um eine entsprechende Anzahl höherwertige Bits der vom Linearisierungssystem gelieferten Datenworte, die den zu erzeugenden linearisierten Daten entsprechen, zu erzeugen. Die übrigen geringerwertigen Bits der vom Linearisierungssystem gelieferten Datenworte werden durch die übrigen geringerwertigen Bits der Produktdatenworte gebildet.

Der Erfindung liegt die Aufgabe zugrunde, einen Funkempfänger der eingangs genannten Art so zu verbessern, daß die Bitfehlerrate des Ausgangssignals des digitalen Signalverarbeitungsteiles und der Speicherbedarf für die Signalverarbeitung möglichst gering sind.

Diese Aufgabe wird bei einem Funkempfänger der eingangs genannten Art durch die Merkmale des kennzeichnenden Teils des Patentanspruchs 1 gelöst.

Die Erfindung geht dabei von der Erkenntnis aus, daß vom Funkempfänger aufgrund der Dynamikkompression zwar Nachrichtensignale mit einem großen Dynamikumfang verarbeitbar sind, die Dynamikkompression jedoch auch nichtlineare Verzerrungen zur Folge hat, wodurch im Ausgangssignal des digitalen Signalverarbeitungsteils Bitfehler hervorgerufen werden können. Diese nichtlinearen Verzerrungen können mit Hilfe des im digitalen Signalverarbeitungsteil angeordneten Expandierungsteil kompensiert werden, so daß im Ausgangssignal des digitalen Signalverarbeitungsteils die durch die nichtlinearen Verzerrungen hervorgerufenen Bitfehler kompensiert werden.

Der analoge Empfangsteil besteht dabei beispielsweise aus einem Eingangskreis, der das empfangene Nachrichtensignal frequenzselektiert, sowie aus einem oder mehreren Zwischenfrequenzmischern zur Umsetzung des Nachrichtensignals in eine oder mehrere Zwischenfrequenzen. Der analoge Empfangsteil enthält weiter eine Einrichtung zur nichtlinearen Dynamikkompression. Dabei wird das Eingangssignal dieser Einrichtung zur Dynamikkompression je nach Eingangspegel entweder komprimiert oder begrenzt. Eine derartige Kompressionskennlinie zur Dynamikkompression ist beispielsweise in DE 39 25 305 A1 dargestellt und beschrieben. Dabei weist die Kompressionskennlinie in einem ersten Bereich einen logarithmischen Verlauf auf, während in einem anschließenden zweiten Bereich eine Begrenzung erfolgt. Anschließend erfolgt eine Umsetzung ins Basisband, wobei zwei Quadraturkomponenten erzeugt werden. Diese werden analog/digital gewandelt und die so gewonnenen digitalisierten Quadraturkomponenten werden im digitalen Signalverarbeitungsteil weiterverarbeitet. Zur Kompensation der durch die Dynamikkompression hervorgerufenen nichtlinearen Verzerrungen erfolgt nach der Analog/Digital-Wandlung im Expandierungsteil eine Expandierung der zwei digitalisierten Quadraturkomponenten. Die so gewonnenen expandierten Quadraturkomponenten werden anschließend in bekannter Weise von dem digitalen Signalverarbeitungsteil, der beispielsweise aus einem Kanalschätzer sowie einem Entzerrer gebildet wird, weiterverarbeitet. Hierdurch wird es möglich, mit einem preisgünstigen A/D-Wandler Nachrichtensignale mit einem großen Dynamikpegelbereich zu verarbeiten, ohne daß störende nichtlineare Verzerrungen auftreten. Durch die Expandierung werden die durch die Dynamikkompression hervorgerufenen Verzerrungen rückgängig gemacht und damit auch die durch diese Verzerrungen ohne Expandierung entstehenden Bit-Fehler im Ausgangssignal des digitalen Signalverarbeitungsteils vermieden.

Gemäß der Erfindung weist der Expandierungsteil eine Tabelle auf, in der zu jedem Abtastwertepaar der digitalisierten Quadraturkomponenten jeweils ein Expansionsfaktor speicherbar ist. Da die nichtlineare DynamikKompression auf den Betrag des Nachrichtensignals wirkt, kann anstelle von jeweils einem Umkehrfunktionswertepaar in der Tabelle lediglich jeweils ein Expansionsfaktor gespeichert werden. Die expandierten Quadraturkomponenten am Ausgang des Expandierungsteils ergeben sich dann als Produkt aus dem jeweiligen Expansionsfaktor und den digitalisierten Quadraturkomponenten. Hierdurch kann der Speicherplatzbedarf für die Tabelle wesentlich verringert werden.

Bei einer weiteren Ausgestaltungsform sind die Speicherzellen der Tabelle jeweils durch ein Abtastwertepaar der digitalisierten Quadraturkomponenten adressierbar. Das Abtastwertepaar der digitalisierten Quadraturkomponenten dienen somit gleichzeitig zur Adressierung der jeweiligen Speicherzelle der Tabelle, in der entweder die Umkehrfunktionswertepaare selbst oder die Expansionsfaktoren gespeichert sind.

Bei einer weiteren vorteilhaften Ausgestaltungsform sind die Speicherzellen der Tabelle durch lediglich eine vorgebbare Anzahl höherwertiger Bit eines Abtastwertepaars der digitalisierten Quadraturkomponenten adressierbar. Die Adresse der jeweiligen Speicherzelle ergibt sich somit nicht aus der vollen Wortbreite der Werte des Abtastwertepaars der digitalisierten Quadraturkomponenten, sondern nur aus den oberen, d.h. den höherwertigsten Bit, jedes digitalisierten Quadraturkomponentenwertes. Hierdurch wird die Größe der Tabelle wesentlich verringert, ohne daß nennenswerte Verzerrungen des Nachrichtensignals auftreten.

Im folgenden wird die Erfindung anhand der in den Fig. dargestellten Ausführungsbeispiele näher erläutert. Es zeigen:

Fig. 1 einen Funkempfänger,

Fig. 2 ein digitales Nachrichtenübertragungssystem mit einem Funkempfänger,

Fig. 3a, b jeweils ein Ausführungsbeispiel für einen Expandierungsteils eines Funkempfängers,

Fig. 4 eine Kompressionskennlinie einer nichtlinearen Dynamikkompression.

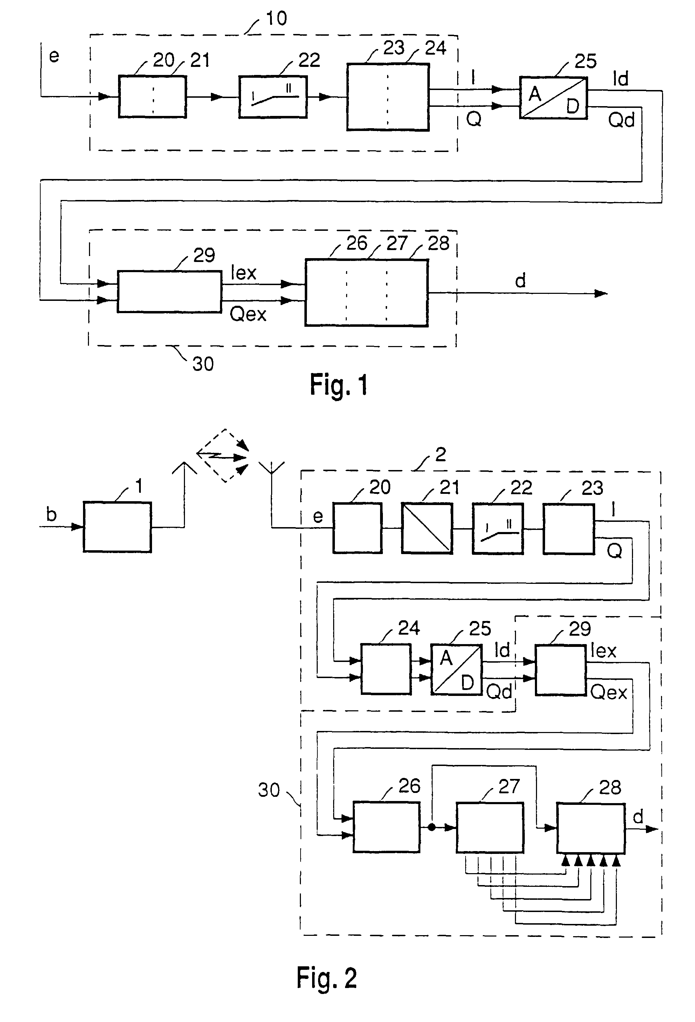

Der in Fig. 1 dargestellte Funkempfänger besteht aus einem analogen Empfangsteil 10, einem Analog/Digital-Wandler 25 und einem digitalen Signalverarbeitungsteil 30. Dem analogen Empfangsteil 10 wird ein phasen- oder frequenzmoduliertes Nachrichtensignal e zugeführt. Der analoge Empfangsteil 10 besteht aus einem Eingangsteil 20 zur Frequenzselektion, einem ZF-Mischer 21, einem ZF-Verstärker 22 mit nichtlinearer Dynamikkompression sowie einem Basisbandumsetzer 23 und einem Abtasthalteglied 24. Am Ausgang des Abtasthaltegliedes 24 anliegende Quadraturkomponenten I und Q werden dem Analog/Digital-Wandler 25 zugeführt, an dessen Ausgang digitalisierte Quadraturkomponenten Id, Qd anliegen. Die digitalisierten Quadraturkomponenten Id und Qd werden dem digitalen Signalverarbeitungsteil 30 zugeführt, der aus einem Expandierungsteil 29, einem Schreib-Lese-Speicher 26, einem Kanalschätzer 27 sowie einem Entzerrer 28 besteht. Am Ausgang des Expandierungsteils 29 liegen expandierte Quadraturkomponenten Iex und Qex, während am Ausgang des Entzerrers 28 ein dekodiertes Nachrichtensignal anliegt.

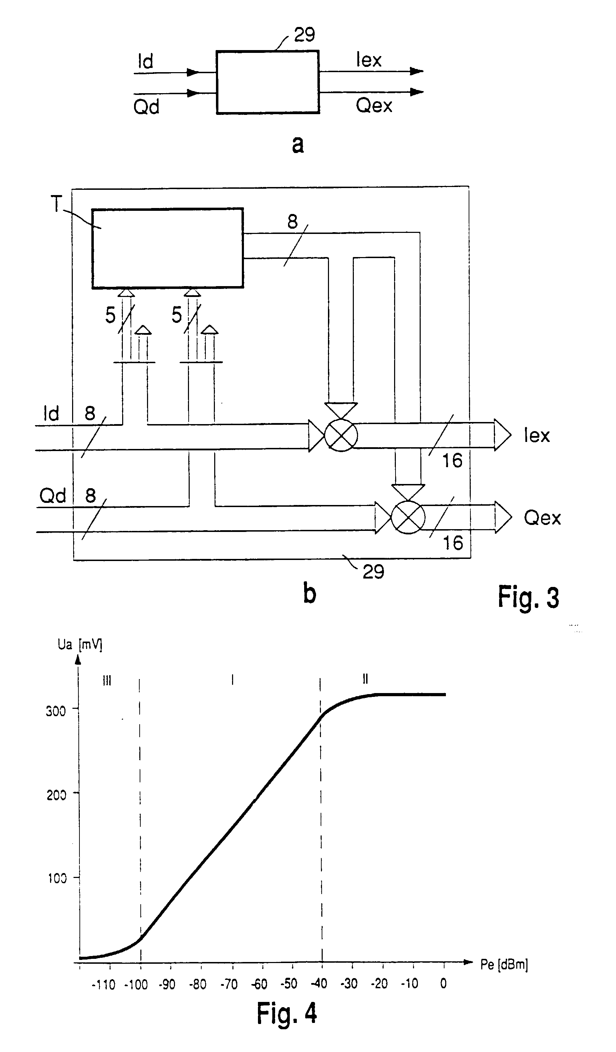

Das von dem in Fig. 1 dargestellten Funkempfänger empfangene Nachrichtensignal e wird im Eingangskreis 20 zunächst frequenzselektiert und anschließend mit Hilfe des ZF-Mischers in eine Zwischenfrequenz umgesetzt. Das so umgesetzte Signal wird im ZF-Verstärker 22 anschließend einer nichtlinearen Dynamikkompression unterzogen. Der Kennlinienverlauf einer derartigen Dynamikkompressionskennlinie ist im Block 22 des ZF-Verstärkers angedeutet. Der ZF-Verstärker weist in einem ersten Bereich I seiner Leistungsübertragungskennlinie eine Dynamikkompression und in einem daran anschließenden Bereich II eine Begrenzung seines Eingangssignals auf. Eine derartige Dynamikkompressionskennlinie ist in der bereits in der Beschreibungseinleitung genannten DE 39 25 305 A1 (sowie in Fig. 4) gezeigt und beschrieben. Durch die nichtlineare Dynamikkompression des ZF-Verstärkers 22 wird es möglich, einen preisgünstigen Analog/Digital-Wandler einzusetzen und andererseits Signale mit einem großen Dynamikpegelbereich zu verarbeiten, jedoch auf Kosten nichtlinearer Verzerrungen. Im analogen Empfangsteil 10 erfolgt im Anschluß an die Dynamikkompression im Basisbandumsetzer 23 eine Zerlegung des Nachrichtensignals in zwei Quadraturkomponenten I und Q, die schließlich im Abtasthalteglied 24 abgetastet und dem Analog/Digital-Wandler 25 zugeführt werden.

Zur Entzerrung der durch die Dynamikkompression 22 hervorgerufenen Verzerrungen werden die digitalisierten Quadraturkomponenten Id und Qd im Expandierungsteil 29 expandiert. Eine erste Möglichkeit besteht darin, daß im Expandierungsteil für jedes Abtastwertepaar der digitalisierten Quadraturkomponenten Id, Qd Umkehrfunktionspaare zur linearen Entzerrung der digitalisierten Quadraturkomponenten Id, Qd ermittelt werden. Die Umkehrfunktionswertepaare können dabei aus der Umkehrfunktion der durch eine mathematische Funktion beschriebenen nichtlinearen Kennlinie des ZF-Verstärkers 22 berechnet werden. Die Expandierung erfolgt dann gemäß der berechneten Umkehrfunktionswertepaare. Da die Dynamikkompression des Verstärkers 22 auf den Betrag der Quadraturkomponenten I, Q wirkt, sind die Umkehrfunktion zur Dynamikkompressionskennlinie und somit auch die Umkehrfunktionswerte des Umkehrfunktionswertepaars von den Quadraturkomponenten I und Q abhängig.

Eine jeweilige Neuberechnung der Umkehrfunktion für jedes Abtastwertepaar Id, Qd der Quadraturkomponenten erfordert einen hohen Berechnungsaufwand. Aus diesem Grunde wird bei einer zweiten Möglichkeit nicht für jedes Abtastwertepaar die Umkehrfunktion neu berechnet, sondern es werden in einer Tabelle des Expandierungsteils 29 zu jedem Abtastwertepaar der digitalisierten Quadraturkomponenten Id, Qd die expandierten Quadraturkomponentenwerte Iex, Qex gespeichert. Die Speicherzellen der Tabelle sind dann jeweils durch ein Abtastwertepaar der digitalisiserten Quadraturkomponenten Id, Qd adressierbar. Der Nachteil dieser Lösung ist der enorme Speicherplatzbedarf. So ergibt sich beispielsweise für eine Wortbreite des Analog/Digital-Wandlers 25 von 8 Bit und eine Wortbreite der expandierten Werte Iex, Qex von 16 Bit für die Größe der Tabelle:

$$2^8 * 2^8 * 2 * 16 \text{ Bit} = 2097152 \text{ Bit}$$

Dieser Speicherplatzbedarf kann reduziert werden, indem, gemäß der Erfindung in der Tabelle nicht die expandierten Signalwerte für die expandierten Quadraturkomponentenwerte Iex, Qex abgespeichert werden, sondern lediglich ein Expansionsfaktor F (Id, Qd), der ebenfalls von den Quadraturkomponenten Id und Qd abhängig ist. Die Berechnung der expandierten Quadraturkomponentenwerte Iex, Qex erfolgt dann nach folgender Vorschrift:

$$Iex = F(Id,Qd) * Id$$

$$Qex = F(Id,Qd) * Qd$$

Hiermit ergibt sich für eine Wortbreite des Analog/Digital-Wandlers 25 von beispielsweise 8 Bit und eine Wortbreite des Expansionsfaktors von 8 Bit für die Größe der Tabelle:

$$2^8 * 2^8 * 8 \text{ Bit} = 524288 \text{ Bit}$$

Eine weitere Reduzierung der Tabellengröße kann dadurch erreicht werden, daß sich die Adresse der Speicherzelle der Tabelle nicht aus der vollen Wortbreite der Quadraturkomponenten I, Q ergibt, sondern daß nur die höherwertigen Bit eines Abtastwertepaares der digitalisierten Quadraturkomponentenwerte Id, Qd der Adressierung dienen. Die Berechnung der expandierten Signalwerte stellt sich dann wie folgt dar:

$$Iex = F(Im,Qm) * Id$$

$$Qex = F(Im,Qm) * Qd$$

Dabei kennzeichnet Im und Qm jeweils die höherwertigen Bit eines Abtastwertepaars der Quadraturkomponenten Iα und Qα. Eine detailliertere Darstellung einer derartigen Bildungsvorschrift ist in Fig. 3 dargestellt und beschrieben. Für eine Wortbreite des Analog/Digital-Wandlers 25 von 8 Bit und bei einer Expansionsfaktorberechnung aus den höherwertigen 5 Bits (m=5) ergibt sich somit für die Größe der Tabelle:

$$2^5 * 2^5 * 8 \text{ Bit} = 8192 \text{ Bit}.$$

Auf diese Weise verbleiben lediglich sehr geringe Restverzerrungen des Nachrichtensignals, die jedoch bei der weiteren digitalen Signalverarbeitung nicht störend wirken. Die weitere digitale Signalverarbeitung der so expandierten Quadraturkomponentenwerte Iex, Qex erfolgt in bekannter Weise mit Hilfe einer Zwischenspeicherung im Schreib-Lese-Speicher 26 mit anschließender Kanalschätzung 27 und Entzerrung 28, wie dies beispielsweise in DE 39 05 305 A1 beschrieben ist.

Fig. 2 zeigt ein digitales Funkübertragungssystem, bei dem die zu übertragende Information in Form eines Binärsignals b über einen Sender 1 abgestrahlt wird. Zwischen dem Sender 1 und dem Empfänger 2 liegt eine durch einen Pfeil gekennzeichnete Funkübertragungsstrecke. Das ausgesendete Signal wird von einem Funkempfänger 2 empfangen. Der Funkempfänger 2 besteht aus einem analogen Empfangsteil 20, 21, 22, 23, 24, einem Analog/Digital-Wandler 25 und einem digitalen Signalverarbeitungsteil 30.

Die Funktionen einzelner Komponenten des digitalen Übertragungssystems sind im wesentlichen bereits im Zusammenhang mit Fig. 1 beschrieben und auch bereits in DE 39 25 305 AI enthalten. Im Gegensatz zu dem in DE 39 25 305 AI beschriebenen digitalen Übertragungssystem weist der digitale Signalverarbeitungsteil 30 einen Expandierungsteil 29 auf. Dieser bewirkt eine Kompensation der nichtlinearen Dynamikkompression 22 des analogen Empfangsteils 20, 21, 22, 23, 24, wie dies bereits im Zusammenhang mit Fig. 1 beschrieben ist.

Die Fig. 3a, 3b zeigen jeweils ein Ausführungsbeispiel eines Expandierungsteils 29 für den digitalen Signalverarbeitungsteil eines Funkempfängers. Der Expandierungsteil 29 ermittelt expandierte Quadraturkomponentenwerte Iex, Qex aus einem Abtastwertepaar digitalisierter Quadraturkomponenten Id, Qd. Dazu ist in Fig. 3a dargestellt, daß die digitalisierten Quadraturkomponentenwerte Id, Qd dem im wesentlichen aus einer Tabelle gebildeten Expandierungsteil 29 zugeführt werden. Am Ausgang des Expandierungsteils 29 liegen die expandierten Quadraturkomponentenwerte Iex, Qex an. Wie bereits im Zusammenhang mit Fig. 1 beschrieben wurde, sind in der Tabelle des Expandierungsteils 29 zu jedem Abtastwertepaar der digitalisierten Quadraturkomponenten Id, Qd ein Umkehrfunktionswertepaar, d.h. die expandierten Quadraturkomponentenwerte Iex, Qex oder ein Expansionsfaktor gespeichert. Zur Adressierung der einzelnen Speicherzellen der Tabelle T wird jeweils das Wertepaar Id, Qd verwendet.

Fig. 3b zeigt ein weiteres Ausführungsbeispiel eines Expandierungsteils 29. Die digitalisierten Quadraturkomponentenwerte Id, Qd weisen bei dem in Fig. 3b dargestellten Ausführungsbeispiel eine Wortbreite von jeweils 8 Bit auf, d.h. im Funkempfänger kommt ein Analog/Digital-Wandler mit 8 Bit Wortbreite zum Einsatz. Dies ist in Fig. 3b durch /8 an den jeweiligen Signalpfeilen symbolisiert. Zur Reduzierung der Tabellengröße der Tabelle T werden zur Bildung der expandierten Quadraturkomponenten Iex, Qex von den 8 Bit der digitalisierten Quadraturkomponenten Id, Qd, lediglich die höherwertigen Bit, beispielsweise die oberen 5 Bit zur Adressierung der Tabelle T verwendet, während die verbleibenden niederwertigen Bit unberücksichtigt bleiben. Dies ist in Fig. 3b durch die Signalpfeile mit /5 veranschaulicht. In der Tabelle T ist zu den jeweiligen digitalisierten Quadraturkomponenten Id, Qd ein Expansionsfaktor gespeichert, der mit Hilfe der auch als Adresse dienenden digitalisierten Quadraturkomponenten Id, Qd selektiert werden kann. Der Expansionsfaktor kann nur positive Werte annehmen. Der Expansionsfaktor wird mit den digitalisierten Quadraturkomponenten Id, Qd multipliziert und ergibt so die expandierten Quadraturkomponenten Iex, Qex. Die maximale Wortbreite des Expansionsfaktors ist frei wählbar und bestimmt die gesamte Wortbreite der expandierten Quadraturkomponenten Iex, Qex. So ergibt sich bei einem Analog/Digital-Wandler mit 8 Bit Wortbreite und einem maximalen Expansionsfaktor von 255 eine endgültige Wortbreite der expandierten Quadraturkomponenten Iex, Qex von jeweils 16 Bit. Damit ergibt sich bei dem in Fig. 3b dargestellten Ausführungsbeispiel für die Tabelle T eine Größe von:

$$2^5 * 2^5 * 8 = 8192 \text{ Bit.}$$

Fig. 4 zeigt eine schematische Darstellung einer bereichsweise logarithmischen Kennlinie zur nichtlinearen Dynamikkompression, wie sie bereits bei dem im Zusammenhang mit den Fig. 1 und 2 beschriebenen ZF-Verstärker 22 erläutert wurde und auch bereits in DE 39 25 305 AI enthalten ist. Die Kennlinie zeigt ein mit Ua bezeichnetes Ausgangssignals des in den Fig.1 und 2 dargestellten ZF-Verstärkers 22 in mV in Abhängigkeit eines mit Pe bezeichneten Eingangspegels eines Eingangssignals des ZF-Verstärkers 22 in dBm. Die Kennlinie weist einen linearen Bereich III, einen logarithmischen Bereiche I und einen Begrenzungsbereich II auf. Aufgrund der gewählten einfach-logarithmischen Darstellung erscheint der Bereich II als Gerade. Die in Fig. 4 dargestellte Kennlinie dient auch der Berechnung der Umkehrfunktionswerte bzw. der Expansionswerte zur Speicherung dieser Werte in den in Fig. 3a, 3b gezeigten Tabellen. Hierzu ist zunächst die Gleichung der Kennlinie zu ermitteln. Dies entspricht der Berechnung der Kompressionswerte des ZF-Verstärkers 22 (Fig. 1, 2). Anschließend wird die Umkehrfunktion hierzu berechnet, die noch digital approximiert und gegebenenfalls quantisiert wird.

## Patentansprüche

1. Funkempfänger (2) für ein phasen- oder frequenzmoduliertes Nachrichtensignal (e) mit einem analogen Empfangsteil (10) mit einer nichtlinearen Dynamikkompression (22), mit einem Analog/Digital-Wandler (25) und mit einem digitalen Signalverarbeitungsteil (30).
dadurch gekennzeichnet,

daß der digitale Signalverarbeitungsteil (30) zur Kompensation der nichtlinearen Dynamikkompression (22) des analogen Empfangsteils (10) einen Expandierungsteil (29) aufweist und daß der Expandierungsteil (29) eine Tabelle (T) aufweist, in der zu jedem Abtastwertepaar von digitalisierten Quadraturkomponenten (Id. Qd) des Nachrichtensignals jeweils ein Expansionsfaktor speicherbar ist, wobei aus dem Produkt des jeweiligen Expansionsfaktors und einer jeweiligen digitalisierten Quadraturkomponente (Id, Qd) expandierte Quadraturkomponenten (Iex, Qex) gebildet werden.

2. Funkempfänger nach Anspruch 1,
   <u>dadurch gekennzeichnet</u>,
   daß die Speicherzellen der Tabelle (T) jeweils durch ein Abtastwertepaar der digitalisierten Quadraturkomponenten (Id, Qd) adressierbar sind.

3. Funkempfänger nach Anspruch 1 oder 2.
   <u>dadurch gekennzeichnet</u>,
   daß die Speicherzellen der Tabelle (T) durch lediglich eine vorgebbare Anzahl höherwertiger Bit eines Abtastwertepaars der digitalisierten Quadraturkomponenten (Id. Qd) adressierbar sind.

**Claims**

1. Radio receiver (2) for a phase or frequency modulated information signal (e), comprising an analog receiving section (10) with a non-linear dynamic compression (22), an analog-to-digital converter (25) and a digital signal processing section (30), characterized in that the digital signal processing section (30) comprises an expansion section (29) to compensate for the non-linear dynamic compression (22) of the analog receiving section (10), and in that the expansion section (29) comprises a Table (T) in which an expansion factor can be stored for each pair of sample values of the digitized quadrature components (Id, Qd) of the information signal, expanded quadrature components (Iex, Qex) being formed from the product of each expansion factor and each digitized quadrature component (Id, Qd).

2. Radio receiver as claimed in Claim 1, characterized in that the memory cells of the Table (T) can each be addressed by a pair of sample values of the digitized quadrature components (Id, Qd).

3. Radio receiver as claimed in Claim 1 or 2, characterized in that the memory cells of the Table (T) can be addressed by only a predeterminable number of most significant bits of a pair of sample values of the digitized quadrature components (Id, Qd).

**Revendications**

1. Récepteur radio (2) pour un signal de télécommunications (e) modulé en phase ou en fréquence, comprenant une partie de réception analogique (10) avec une compression de la dynamique non linéaire (22), un convertisseur analogique-numérique (25) et une partie de traitement de signaux numérique (30),
   caractérisé en ce que la partie de traitement de signaux numérique (30) comporte, pour la compensation de la compression non linéaire (22) de la dynamique de la partie de réception analogique (10), une partie d'expansion (29), et que la partie d'expansion (29) comporte une table (T), dans laquelle un facteur d'expansion peut chaque fois être mis en mémoire pour chaque paire de valeurs échantillonnées des composantes en quadrature numérisées (Id, Qd) du signal de télécommunications, sachant qu'à partir du produit du facteur d'expansion respectif et d'une composante en quadrature numérisée respective (Id, Qd), on peut former des composantes en quadrature ayant subi une expansion (Iex, Qex).

2. Récepteur radio suivant la revendication 1, caractérisé en ce que les emplacements de mémoire de la table (T) peuvent être adressés respectivement par une paire de valeurs échantillonnées des composantes en quadrature numérisées (Id, Qd).

3. Récepteur radio suivant la revendication 1 ou 2, caractérisé en ce que les emplacements de mémoire de la table (T) peuvent être adressés simplement par un nombre prédéterminé de bits de poids fort d'une paire de valeurs échantillonnées des composantes en quadrature numérisées (Id, Qd).

Fig. 1

Fig. 2

7

Fig. 3

Fig. 4